**Europäisches Patentamt**

**European Patent Office**

**Office européen des brevets**

(19)

(11) Veröffentlichungsnummer : **0 073 375**
**B1**

(12) **EUROPÄISCHE PATENTSCHRIFT**

(45) Veröffentlichungstag der Patentschrift :
03.12.86

(21) Anmeldenummer : **82107332.7**

(22) Anmeldetag : **12.08.82**

(51) Int. Cl.⁴ : **G 01 N 24/08**, A 61 B 5/05

(54) **Hochfrequenzfeld-Einrichtung in einer Kernspinresonanz-Apparatur.**

(30) Priorität : **24.08.81 DE 3133432**

(43) Veröffentlichungstag der Anmeldung :
**09.03.83 Patentblatt 83/10**

(45) Bekanntmachung des Hinweises auf die Patenterteilung : **03.12.86 Patentblatt 86/49**

(84) Benannte Vertragsstaaten :
**DE GB NL**

(56) Entgegenhaltungen :
**EP-A- 0 009 288**
**JOURNAL OF PHYSICS E; SCIENTIFIC INSTRU-**
**MENTS, Band 9, Nr. 21, Januari 1976, Seiten 79-80, I.**
**ZUPANCIC u.a.: "Coils producing a magnetic field**
**gradient for diffusion measurement with NMR"**

(73) Patentinhaber : **Siemens Aktiengesellschaft Berlin**
**und München**
**Wittelsbacherplatz 2**
**D-8000 München 2 (DE)**

(72) Erfinder : **Krause, Norbert, Dr.**
**Baiersdorfer Strasse 22**
**D-8551 Heroldsbach (DE)**

# 0 073 375

**Beschreibung**

Die Erfindung bezieht sich auf eine Einrichtung zur Erzeugung eines zumindest weitgehend homogenen magnetischen Hochfrequenzfeldes und/oder zum Empfang von hochfrequenten Signalen in einer Kernspinresonanz-Apparatur, insbesondere zur Zeugmatographie, mit mindestens zwei sich auf mindestens einer gedachten Zylindermantelfläche parallel zur Richtung der Zylinderachse erstreckenden, gegensinnig stromdurchflossenen Leiterstücken vorbestimmter Länge, die mit mindestens einer externen Energieeinspeisungs- bzw. Empfangsvorrichtung verbunden sind. Eine derartige Einrichtung zur Erzeugung eines magnetischen Hochfrequenzfeldes ist aus der veröffentlichten europäischen Patentanmeldung EP-21 535 A1 bekannt.

Auf dem Gebiet der medizinischen Diagnostik sind Abbildungsverfahren vorgeschlagen worden, bei denen durch rechnerische oder meßtechnische Analyse integraler Protonenresonanzsignale aus der räumlichen Spindichte- und/oder Relaxationszeitverteilung eines zu untersuchenden Körpers ein Bild ähnlich einem Röntgentomogramm konstruiert wird. Die entsprechende Methode wird auch als Zeugmatographie bezeichnet (« Nature », Band 242, 1973, Seiten 190 und 191).

Zur Anwendung der Kernspinresonanz wird der zu untersuchende, beispielsweise menschliche Körper in ein starkes homogenes Magnetfeld eingebracht. Dieses auch als Grundfeld bezeichnete Magnetfeld ist von stationären und/oder gepulsten Gradientenfeldern überlagert. Außerdem muß ein senkrecht zu dem Grundfeld orientiertes Hochfrequenzfeld ausgebildet werden, das ebenfalls möglichst homogen ist. Hierbei sind die Systemabmessungen den Dimensionen des zu untersuchenden Körpers so anzupassen, daß der Körper in das die Magnetfelder erzeugende Leitersystem ohne weiteres eingeschoben werden kann.

Bei einer Apparatur der Kernspin-Tomographie bzw. Zeugmatographie hängt bekanntlich die Qualität der erzeugten Schnittbilder von dem Signal-Rausch-Verhältnis des induzierten Kernspinresonanzsignals ab. Da dieses Signal-Rausch-Verhältnis seinerseits von dem verwendeten magnetischen Grundfeld abhängt und mit der Frequenz steigt, ist man bestrebt, bei hohen Grundfeldern hohe Frequenzen vorzusehen (vgl. « J. Phys. E : Sci. Instrum. », Vol. 13, 1980, Seiten 38 bis 44).

Bei den bekannten Kernspinresonanz-Apparaturen (vgl. z. B. die genannte EP) können jedoch aus physikalischen Gründen nur verhältnismäßig niedrige Frequenzen von etwa 5 MHz vorgesehen werden. Die hochfrequenten Magnetfelder werden dabei durch Spulen, die insbesondere Sattelform haben, erzeugt. Derartige auf mindestens einer gedachten Zylinderfläche angeordnete Spulen weisen gerade, sich parallel zur Richtung der Zylinderachse erstreckende Leiterstücke und an den Stirnseiten bogenförmige, in Umfangsrichtung verlaufende Leiterstücke auf, wobei der Strom in den Leiterstücken der einen geraden Seite der Spule entgegengesetzt zum Strom in der anderen geraden Seite fließt. Die axiale Länge der geraden Leiterstücke und damit der Spulen ist durch die Abmessungen des zu untersuchenden Körpers vorbestimmt, wobei die gesamte Drahtlänge der Spulen beispielsweise einige Meter beträgt. Bei Spulen entsprechender Abmessungen treten jedoch bei den angestrebten höheren Frequenzen über 5 MHz aufgrund des zunehmenden Einflusses der verteilten Kapazitäten Phasenverschiebungen der Felder zwischen dem Leiteranfang und -ende der Spulen auf, da ihre Leiterlängen in die Größenordnung der Wellenlänge der Hochfrequenz zu liegen kommen. Aufgrund dieser Phasenverschiebungen wird die Funktionsfähigkeit der das Hochfrequenzfeld erzeugenden Spulen mit zunehmender Frequenz entsprechend vermindert. Daneben treten auch Verkopplungseffekte mit metallischen Teilen der die Hochfrequenzspulen umgebenden Bauteile wie z. B. mit Gradientenspulen oder dem Grundfeldmagneten auf. Dies führt zu zusätzlichen Störungen. Die damit verbundenen Wirbelströme schwächen das Hochfrequenzfeld im Inneren des zu untersuchenden Körpers wegen des Skin-Effektes und machen es inhomogen. Eine Erhöhung der Frequenzen und damit des Signal-Rausch-Verhältnisses ist somit bei den bekannten Kernspinresonanz-Apparaturen nicht ohne weiteres möglich.

Aufgabe der vorliegenden Erfindung ist es deshalb, eine Kernspinresonanz-Apparatur mit einer Einrichtung zur Erzeugung eines zumindest weitgehend homogenen magnetischen Hochfrequenzfeldes der eingangs genannten Art so auszugestalten, daß ein verhältnismäßig hohes Signal-Rausch-Verhältnis ermöglicht wird, indem entsprechend hohe Frequenzen von beispielsweise 20 MHz oder höher anwendbar sind.

Diese Aufgabe wird erfindungsgemäß dadurch gelöst, daß eine zumindest weitgehend hochfrequenzdichte, jedoch niederfrequenzdurchlässige, elektrisch gut leitendes Material enthaltende Hülle in einem vorbestimmten Abstand konzentrisch bezüglich der gedachten Zylindermantelfläche um die Leiterstücke angeordnet und ebenfalls an die Einspeisungs- bzw. Empfangsvorrichtung angeschlossen ist und daß die mindestens ein Leiterpaar bildenden Leiterstücke jeweils an ihrem mit der Energieeinspeisungs- bzw. Empfangsvorrichtung nicht-verbundenen Ende mit die Wellen des Hochfrequenzfeldes reflektierenden Mitteln abgeschlossen sind, so daß mit dem aus der Hülle und dem mindestens einen Leiterpaar gebildeten Leitersystem ein gleichphasig schwingendes Hochfrequenzfeld ausgebildet ist.

Die mit dieser Gestaltung erreichten Vorteile bestehen insbesondere darin, daß auf dem Leiterpaar und der Hülle eine Wellenausbreitung mit einer sehr hohen Frequenz ermöglicht wird, wobei Resonanzverhältnisse eingestellt werden, so daß im gesamten interessierenden Volumen gleichphasig schwingende Felder entstehen, d. h. daß auf dem Leiterpaar stehende Wellen ausgebildet werden. Die im allgemeinen zur Resonanz von hohen Frequenzen wie z. B. von 20 MHz erforderlichen Längen der Leiterstücke werden dabei vorteilhaft auf ein dem zu untersuchenden Körper angepaßtes Maß durch schaltungstechnische Maßnahmen an dem der Energieeinspeisungsseite abgewandten Ende der Leiterstücke reduziert. Auf diese Weise können sehr hohe Frequenzen vorgesehen werden, und das Signal-Rausch-Verhältnis ist entsprechend hoch. Da ferner die gemeinsame Hülle um das Leiterpaar zumindest weitgehend hochfrequenzdicht, jedoch niederfrequenzdurchlässig ausgebildet ist, können Verkopplungseffekte mit Bauteilen außerhalb der Hülle weitgehend ausgeschlossen werden. Die Hülle stellt somit neben einem Leitkörper für das Hochfrequenzfeld eine Hochfrequenz-Abschirmung gegenüber diesen Bauteilen dar. Hingegen können sich aufgrund der Niederfrequenzdurchlässigkeit der Hülle in dem Volumen, in das der zu untersuchende Körper einzubringen ist, die niederfrequenten Gradientenfelder zumindest weitgehend ungehindert ausbreiten.

Vorteilhafte Ausgestaltungen der Hochfrequenzfeld-Einrichtung nach der Erfindung gehen aus den Unteransprüchen hervor.

Zur weiteren Erläuterung der Erfindung und deren in den Unteransprüchen gekennzeichneten Weiterbildungen wird auf die Zeichnung Bezug genommen, in deren Fig. 1 eine Hochfrequenzfeld-Einrictung nach der Erfindung angedeutet ist, von der in Fig. 2 ein Ausschnitt dargestellt ist. Die Fig. 3 und 4 zeigen je eine Ausbildungsmöglichkeit der Leiterstücke für eine solche Hochfrequenzfeld-Einrichtung.

Bei der Kernspinresonanz-Apparatur, insbesondere zur Zeugmatographie, für welche die Hochfrequenzfeld-Einrichtung nach der Erfindung vorzusehen ist, wird von bekannten Kernspinresonanz-Apparaturen ausgegangen. Eine entsprechende Apparatur ist z. B. in der EP-21 535 A1 oder in der DE-OS-28 40 178 dargestellt. Sie weist im allgemeinen mindestens ein bezüglich der z-Achse eines rechtwinkligen x-y-z-Koordinatensystems konzentrisch angeordnetes normal- oder supraleitendes Feldspulensystem auf, mit dem ein starkes, möglichst homogenes Grundfeld in z-Richtung erzeugt wird. Außerdem sind Gradientenspulen zur Erzeugung hinreichend konstanter magnetischer Feldgradienten vorgesehen. Die Magnetspulen erlauben einen axialen Zugang zum homogenen Feldbereich in ihrem Zentrum, d. h. der zu untersuchende, beispielsweise menschliche Körper wird längs der z-Achse in das Magnetfeld eingebracht. Die Anregung der Kernspins erfolgt mittels eines senkrecht zur z-Achse gerichteten, möglichst homogenen Hochfrequenzfeldes.

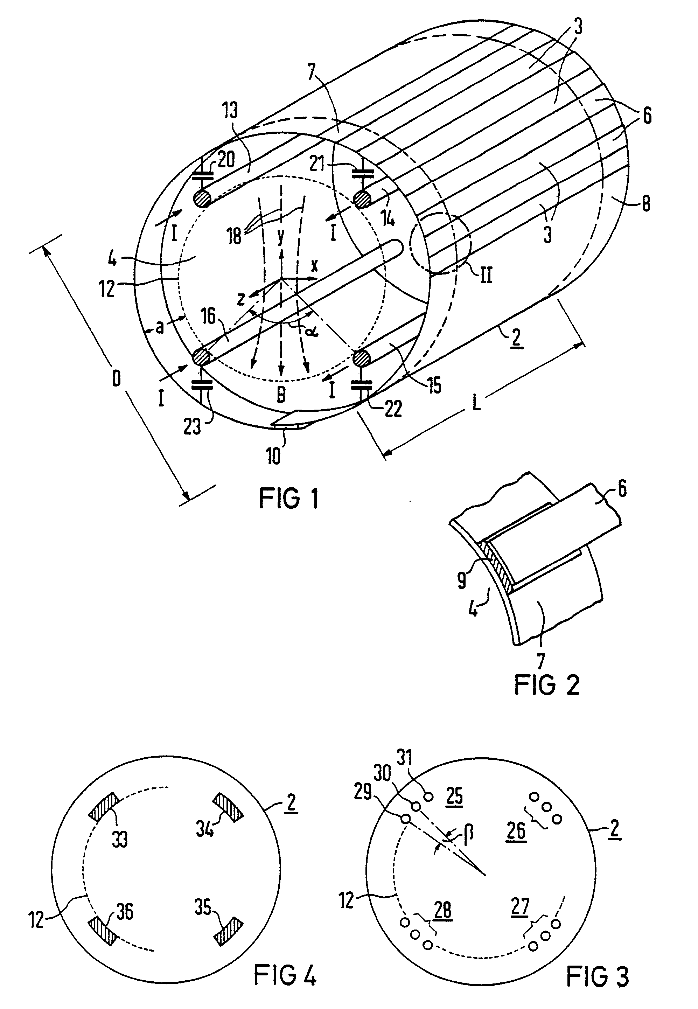

Ein Ausführungsbeispiel einer hierfür geeigneten Hochfrequenzfeld-Einrichtung nach der Erfindung ist in Fig. 1 in Schrägansicht angedeutet. Diese Hochfrequenzfeld-Einrichtung enthält eine käfigartige, hohlzylinderförmige Hülle 2, deren Zylinderachse in Richtung der z-Koordinate eines rechtwinkligen x-y-z-Koordinatensystems orientiert ist. Diese Hülle mit einer axialen Länge L und einem Durchmesser D kann aus einem elektrisch gut leitenden Material wie z. B. aus Kupfer bestehen, das zumindest auf einer Seite versilbert sein kann. Außerdem braucht sie mechanisch nicht vollständig dicht zu sein, sondern kann Öffnungen 3 aufweisen, um das Eindringen eines niederfrequenten Magnetfeldes, z. B. eines Gradientenfeldes, in den von ihr umschlossenen Innenraum 4 zu erleichtern. Die Hülle ist hierzu so ausgestaltet, daß die Ausbildung niederfrequenter Stromschleifen durch Wirbelströme weitgehend unterbunden wird. Gemäß dem Ausführungsbeispiel nach der Figur weist die Hülle 2 in z-Richtung orientierte, untereinander beabstandete bandförmige Längsstäbe 6 auf, die am Anfang und Ende der hohlzylindrischen Hülle durch Ringe 7 und 8 verbunden sind. Diese Verbindung erfolgt jedoch jeweils nur auf einer Seite durch galvanische Kontakte, während sie auf der anderen Seite kapazitiv ist. Wie aus dem in Fig. 2 gezeigten Ausschnitt aus Fig. 1 hervorgeht, überlappen die Längsstäbe 6 den Ring 7, wobei zwischen dem Ring und den Stäben jeweils eine isolierende Folie 9 angeordnet ist. Es wird so in der Überlappungszone eine Kapazität geschaffen, deren Größe so gewählt ist, daß sich ein hochfrequenzmäßig geringer, jedoch niederfrequenzmäßig hoher Übergangswiderstand ausbildet.

Um niederfrequente Kreisströme in den Ringen 7 und 8 zu unterbinden, in ihnen jedoch einen hochfrequenten Kurzschluß zu gewährleisten, sind diese Ringe jeweils in entsprechender Weise durch eine Kapazität unterbrochen. In der Schrägansicht der Figur 1 ist nur für den Ring 7 die durch eine Folie 10 in einem Überlappungsbereich gebildete Kapazität ersichtlich.

Statt der in Fig. 1 angedeuteten Ausführungsform der Hülle 2 aus Ringen 7 und 8 Stäben 6, die aus elektrisch leitendem Vollmaterial bestehen, kann auch eine Hülle aus isolierendem Material vorgesehen werden, die auf mindestens einer ihrer Mantelflächen eine Schicht aus einem elektrisch gut leitenden Material wie z. B. Silber trägt. Die Schichtdicke muß dabei mindestens so groß wie die Eindringtiefe der hochfrequenten Ströme sein. Um die Hochfrequenzdichtigkeit und die Niederfrequenzdurchlässigkeit der Schicht zu gewährleisten, kann diese gegebenenfalls entsprechend strukturiert und mit kapazitativen Unterbrechungen versehen sein.

Die Hülle 2 umschließt mehrere auf mindestens einer gedachten Zylinderfläche 12 liegende elektrische Leiter. Der Abstand a zwischen der Hülle 2 und dem dazu konzentrisch angeordneten, durch eine punktierte Linie angedeuteten Zylinder hat einen vorbestimmten Wert. Es können mindestens zwei ein Leiterpaar bildende Leiterstücke vorgesehen werden, die gegensinnig stromdurchflossen sind. Um möglichst homogene Felder im Inneren der Hülle zu erzeugen, werden jedoch vorteilhaft mindestens vier Leiterstücke zweier Leiterpaare vorgesehen. Eine derartige Anzahl von Leiterstücken ist bei dem Ausführungsbeispiel der Figur zugrundegelegt. Die mit 13 und 14 bezeichneten, gegensinnig stromdurchflossenen Leiterstücke bilden das eine Leiterpaar, während in entsprechender Weise Leiterstücke 15 und 16 das andere Leiterpaar darstellen. Die Leiterstücke jedes Leiterpaares sind dabei auf der Zylindermantelfläche 12 so angeordnet, daß sie in der x-y-Ebene in Umfangsrichtung des Zylinders gesehen einen Bogenwinkel α zwischen 45° und 150°, vorzugsweise von etwa 120° einschließen.

Mit diesem von der Leiterhülle 2 umschlossenen System aus Leiterstücken 13 bis 16 wird erfindungsgemäß ein durch gestrichelte, gepfeilte Linien 18 angedeutetes hochfrequentes Magnetfeld B erzeugt, das zumindest in der Nähe der Zylinderachse weitgehend homogen und senkrecht zur z-Achse gerichtet ist. Hierzu wird von einer in der Figur nicht dargestellten Energieeinspeisungsvorrichtung sowohl in die Leiterstücke 13 bis 16 als auch in die Hülle 2 ein hochfrequenter Strom derart eingespeist, daß sich in diesem System aus Leiterstücken und Hülle stehende Wellen ausbilden, wobei in Resonanz betrieben wird. Wie durch die Strompfeile an den Leiterstücken angedeutet ist, soll dabei der Strom I in einander diametral gegenüberliegenden Leiterstücken in entgegengesetzter Richtung fließen. In dem gesamten interessierenden Volumen entstechen so gleichphasig schwingende Hochfrequenzfelder.

Um die Ausbildung solcher Felder durch das System aus Leiterstücken und Hülle zu ermöglichen, darf der insbesondere von der zu übertragenden Frequenz und der Stromstärke abhängende Abstand zwischen den Leiterstücken und der Hülle nicht zu groß gewählt sein. Bei einem Abstand a zwischen der gedachten Zylindermantelfläche 12 und der Hülle 2 von höchstens 20 cm, vorzugsweise höchstens 10 cm, ist eine für den vorgesehenen Anwendungsfall ausreichende hochfrequenzmäßige Kopplung dieser Teile zu gewährleisten. Als kleinster Wert für den Abstand a werden mindestens 0,5 cm, vorzugsweise mindestens 1 cm gewählt.

Für hohe Frequenzen, beispielsweise um 20 MHz, wären jedoch für einen Resonanzbetrieb Leiterstücke mit einer Länge L von beispielsweise 7,5 m erforderlich. Durch schaltungstechnische Maßnahmen am Anfang oder Ende des Systems aus Leiterstücken 13 bis 16 und Hülle 2 kann jedoch in bekannter Weise die für einen Resonanzbetrieb erforderliche Länge auf das geforderte Maß reduziert werden. Hierzu sind an den Enden der Leiterstücke 13 bis 16 Kapazitäten mit vorbestimmten Werten vorzusehen. Gemäß dem in Fig. 1 dargestellten Ausführungsbeispiel sind als konzentrierte Kapazitäten Kondensatoren 20 bis 23 zwischen die Enden der Leiterstücke und die Hülle 2 geschaltet. Der Wert C dieser Kapazitäten bestimmt sich näherungsweise nach der Formel :

$$C \approx \left[\left|\omega \cdot z_L \cdot \tan\left(\frac{\pi \cdot L}{\lambda}\right)\right|\right]^{-1} \cdot$$

Hierbei sind

$$\omega = 2\,\pi \cdot f$$

die Kreisfrequenz, $Z_L$ der Wellenwiderstand eines Leiterstückes gegen die Hülle un λ die Wellenlänge.

Um den geforderten Resonanzbetrieb zu gewährleisten, muß neben einer Anpassung der Kondensatoren selbstverständlich auch eine Anpassung der mindestens einen Energieeinspeisungsvorrichtung vorgenommen werden. Vorteilhaft wird dabei die Anpassung so gewählt, daß die Strombäuche der in das Leitersystem aus Hülle 2 und Leiterstücken 13 bis 16 eingespeisten Ströme zumindest annähernd in der axialen Mitte, d. h. bei der Länge L/2 der Hülle bzw. der Leiterstücke zu liegen kommt.

Neben der in Fig. 1 angedeuteten Ausführungsform der Kapazitäten durch Kondensatoren 20 bis 23 können zur Kapazitätserzeugung auch kurzgeschlossene Leitungsstücke vorgesehen werden.

Zur Erzeugung eines linear polarisierten Magnetfeldes B ist ein Einspeisungssystem von nur einer Seite, wie es bei dem Ausführungsbeispiel nach Fig. 1 angenommen wurde, nicht unbedingt erforderlich. So kann man beispielsweise auch die Leiter 13 und 16 an der einen und die Leiter 14 und 15 an der anderen Stirnseite der Hochfrequenz-Einrichtung nach der Erfindung an mindestens eine externe Energieeinspeisungsvorrichtung anschließen. Die Kapazitäten sind dabei an den jeweils gegenüberliegenden Seiten der Leiterstücke vorzusehen.

Besonders vorteilhaft kann mit der Hochfrequenzfeld-Einrichtung nach der Erfindung auch ein zirkular polarisiertes Magnetfeld erzeugt werden. Ein solches Feld hat ein besseres Eindringverhalten in den zu untersuchenden Körper als ein linear polarisiertes Hochfrequenzfeld. Der Feldstärkenabfall ist nämlich bei hohen Frequenzen, z. B. über 20 MHz, für ein zirkular polarisiertes Feld wesentlich geringer als für ein gerichtetes, linear polarisiertes Feld. Dies bedeutet, daß hohe Frequenzen in dieser Größenordnung vorgesehen werden können, so daß auch das Signal-Rausch-Verhältnis der Einrichtung entsprechend hoch ist. Zur Erzeugung eines solchen zirkular polarisierten Magnetfeldes ist statt eines einzigen Systems aus Leiterstücken wie bei einem linear polarisierten Magnetfeld ein weiteres entsprechendes System aus Leiterstücken erforderlich. Dieses zweite Leitersystem ist gegenüber dem ersten Leitersystem in Umfangsrichtung bezüglich der Zylinderachse verdreht anzuordnen, wobei die Hochfrequenzströme in den Leiterstücken dieses zweiten Leitersystems um einen vorbestimmten Phasenwinkel, der im Falle von zwei Leitersystemen 90° beträgt, phasenverschoben zu den entsprechenden Hochfrequenzströmen in dem ersten Leitersystem sind. Die Beträge der Hochfrequenzströme in den beiden Leitersystemen sind hingegen zumindest annähernd gleich zu wählen. Eine Hochfrequenzfeld-Einrichtung mit einem zirkular polarisierten Magnetfeld ist mit der deutschen Patentanmeldung P 31 31 946.7 vorgeschlagen.

Um mit dem in Fig. 1 gezeigten Leitersystem aus Hülle 2 und Leiterstücken 13 bis 16 ein gleichphasig schwingendes Hochfrequenzfeld in Resonanz ausbilden zu können, sind z. B. 4 Generatoren als Energieeinspeisungsvorrichtung erforderlich, falls man jedes Leiterstück einzeln anregen will. Diese Zahl von Generatoren kann dadurch auf 2 verringert werden, daß man Leiterstücke gleicher Stromflußrichtung, also die Leiterstücke 13 und 16 sowie die Leiterstücke 14 und 15 parallelschaltet. Ferner ist es im Fall der Parallelschaltung von Leiterstücken möglich, statt 2 Generatoren auch nur einen einzigen Generator vorzusehen, wenn der in die einen parallelgeschalteten Leiterstücke eingespeiste Strom gegenüber dem Strom in den anderen parallelgeschalteten Leiterstücken um $\lambda/2$ phasenverschoben wird. Hierzu kann z. B. ein spezieller Phasenschieber oder ein Leiterkabelstück der Länge $\lambda/2$ verwendet werden. Auf derartige Phasenglieder kann sogar verzichtet werden, wenn man den Strom von den beiden Gegenseiten her einspeist.

Neben der in Fig. 1 dargestellten Stromeinspeisungsart in die vier Leiterstücke 13 bis 16 sind auch andere Anregungsarten, beispielsweise unter Verwendung einer größeren Anzahl von Leiterstücken, möglich. So läßt sich, wie bereits erwähnt, z. B. eine paarweise Anregung der Leiterstücke 13 bis 16 dadurch vornehmen, daß man die Leiterstücke 13 und 16 bzw. die Leiterstücke 14 und 15 parallelschaltet. Das so entstandene Leitersystem kann als ein System mit zwei gegensinnig stromdurchflossenen Leitereinheiten aus jeweils zwei Leiterstücken angesehen werden. Es sind auch Leitersysteme mit mehreren solcher Leitereinheiten möglich, wobei jede Leitereinheit eine größere Anzahl von Leiterstücken umfassen kann. Ein entsprechendes System ist in Fig. 3 schematisch als Querschnitt angedeutet. Dieses in einer Hülle 2 wie z. B. nach Fig. 1 angeordnete System umfaßt vier Leitereinheiten 25 bis 28. Jede dieser Leitereinheiten besteht aus beispielsweise drei parallelen Leiterstücken 29 bis 31 mit beispielsweise kreisförmigem Querschnitt, die auf der Außenmantelfläche mindestens eines gedachten Zylinders 12 angeordnet sind, welcher konzentrisch zu der Hülle 2 ist. Bei dieser Ausführungsform beträgt der in einer radialen Ebene durch benachbarte Leiterstücke 29, 30 bzw. 30, 31 innerhalb einer Leitereinheit begrenzte Bogenwinkel $\beta$ vorteilhaft etwa 5° bis 30°, vorzugsweise etwa 20° bis 25°. Hierdurch wird die Homogenität des hochfrequenten Magnetfeldes noch weiter verbessert.

Eine entsprechende Wirkung kann auch mit der in Fig. 4 als Querschnitt dargestellten Hochfrequenz-Feldeinrichtung nach der Erfindung erzeugt werden. Im Gegensatz zu der Ausführungsform nach Fig. 3 mit Leitereinheiten, die aus drei parallelen Leiterstücken bestehen, sind gemäß der Ausführungsform nach Fig. 4 die mit 33 bis 36 bezeichneten, auf einer gedachten Zylindermantelfläche 12 angeordneten Leitereinheiten jeweils aus einem einzigen bandförmigen Leiterstück gebildet, das entsprechend der Krümmung der Zylindermantelfläche 12 gebogen ist. Die Leiterstücke 29 bis 31 der Leitereinheiten nach Fig. 3 sind somit bei der Ausführungsform nach Fig. 4 quasi zu einem bandförmigen Leiterstück vereinigt.

Bei den Ausführungsbeispielen nach den Figuren wurde davon ausgegangen, daß die Leiterstücke und die Hülle mit mindestens einer externen Energieeinspeisungsvorrichtung verbunden sein sollen. Da die Hochfrequenzfeld-Einrichtung nach der Erfindung ebensogut auch eine Vorrichtung zum Empfang hochfrequenter Signale sein kann, sind in diesem Fall die Leiterstücke und die Hülle mit einem entsprechenden externen Empfängersystem zu verbinden.

## Patentansprüche

1. Einrichtung zur Erzeugung eines zumindest weitgehend homogenen magnetischen Hochfrequenzfeldes und/oder zum Empfang von Hochfrequenzsignalen in einer Kernspinresonanz-Apparatur, insbesondere zur Zeugmatographie, mit mindestens zwei sich auf einer gedachten Zylindermantelfläche parallel zur Richtung der Zylinderachse erstreckenden, gegensinnig stromdurchflossenen Leiterstücken (13 bis 16) vorbestimmter Länge, die mit mindestens einer externen Energieeinspeisungs- bzw. Empfangsvorrichtung verbunden sind, dadurch gekennzeichnet,

a) daß eine zumindest weitgehend hochfrequenzdichte, jedoch niederfrequenzdurchlässige, elektrisch gut leitendes Material enthaltende Hülle (2) in einem vorbestimmten Abstand (a) konzentrisch bezüglich der gedachten Zylindermantelfläche (12) um die Leiterstücke (13 bis 16) angeordnet und ebenfalls an die Energieeinspeisungs- bzw. Empfangsvorrichtung angeschlossen ist und

b) daß die mindestens ein Leiterpaar bildenden Leiterstücke (13, 14 bzw. 15, 16) jeweils an ihrem mit der Energieeinspeisungs- bzw. Empfangsvorrichtung nicht-verbundenen Ende mit die Wellen des Hochfrequenzfeldes reflektierenden Mitteln abgeschlossen sind, so daß mit dem aus der Hülle (2) und dem mindestens einen Leiterpaar gebildeten Leitersystem ein gleichphasig schwingendes Hochfrequenzfeld (B) ausgebildet ist.

2. Hochfrequenzfeld-Einrichtung nach Anspruch 1, gekennzeichnet durch eine resonante Anpassung der Energieeinspeisungs- bzw. Empfangsvorrichtung und der die Wellen des Hochfrequenzfeldes reflektierenden Mittel.

3. Hochfrequenzfeld-Einrichtung nach Anspruch 2, gekennzeichnet durch eine Anpassung der Energieeinspeisungs- bzw. Empfangsvorrichtung und der reflektierenden Mittel derart, daß die Strombäuche der in das Leitersystem eingespeisten bzw. der mit dem Leitersystem empfangenen Ströme zumindest annähernd in der axialen Mitte des Leitersystems liegen.

4. Hochfrequenzfeld-Einrichtung nach einem der Ansprüche 1 bis 3, dadurch gekennzeichnet, daß die Hülle (2) als Käfig aus elektrisch leitenden Teilen (6 bis 8) mit dazwischen befindlichen Durchbrechungen (3) gestaltet ist.

5. Hochfrequenzfeld-Einrichtung nach einem der Ansprüche 1 bis 4, dadurch gekennzeichnet, daß die Leiterstücke (13 bis 16) des mindestens einen Leiterpaares mit Kapazitäten (20 bis 23) vorbestimmter Größe abgeschlossen sind.

6. Hochfrequenzfeld-Einrichtung nach Anspruch 5, dadurch gekennzeichnet, daß als Kapazitäten Kondensatoren (20 bis 23) oder kurzgeschlossene Leitungsstücke zwischen die Enden der Leiterstücke (13 bis 16) des mindestens einen Leiterpaares und die Hülle (2) geschaltet sind.

7. Hochfrequenzfeld-Einrichtung nach Anspruch 5 oder 6, dadurch gekennzeichnet, daß der Wert (C) der Kapazitäten (Kondensatoren 20 bis 23) näherungsweise bestimmt ist nach der Formel

$$C \approx \left[ \left| \omega \cdot z_L \cdot \tan\left(\frac{\pi \cdot L}{\lambda}\right) \right| \right]^{-1}$$

wobei $\omega$ die Kreisfrequenz, $Z_L$ der Wellenwiderstand eines Leiterstückes (13 bis 16) gegen die Hülle (2), L die axiale Ausdehnung der Hülle (2) bzw. der Leiterstücke (13 bis 16) sowie $\lambda$ die Wellenlänge sind.

8. Hochfrequenzfeld-Einrichtung nach einem der Ansprüche 1 bis 7, dadurch gekennzeichnet, daß mindestens zwei parallele Leiterstücke (29 bis 31) zu einer Leitereinheit (25 bis 28) zusammengefaßt sind und daß aus mindestens zwei solcher gegensinnig stromdurchflossenen Leitereinheiten (25 bis 28) und der Hülle (2) ein das Hochfrequenzfeld erzeugendes System gebildet ist.

9. Hochfrequenzfeld-Einrichtung nach einem der Ansprüche 1 bis 8, gekennzeichnet durch Leiterstücke (33 bis 36) aus mindestens einem bandförmigen Leiterstrang.

10. Hochfrequenzfeld-Einrichtung nach einem der Ansprüche 1 bis 9, dadurch gekennzeichnet, daß mindestens zwei Leiterpaare vorgesehen sind.

11. Hochfrequenzfeld-Einrichtung nach Anspruch 10, gekennzeichnet

a) durch ein zweites Leiterpaar, das bezüglich des ersten Leiterpaares auf der gedachten Zylindermantelfläche (12) oder einer weiteren Zylindermantelfläche in Umfangsrichtung um einen vorbestimmten Winkel verdreht angeordnet ist und

b) durch ein zirkular polarisiertes Hochfrequenzfeld mittels eines Hochfrequenzstromes in dem zweiten Leiterpaar, der um einen vorbestimmten Phasenwinkel phasenverschoben zu dem Hochfrequenzstrom in dem ersten Leiterpaar ist, wobei die Beträge der beiden Hochfrequenzströme zumindest annähernd gleich sind.

12. Hochfrequenzfeld-Einrichtung nach Anspruch 10 oder 11, dadurch gekennzeichnet, daß die Leiterpaare auf verschiedenen konzentrischen Zylindermantelflächen angeordnet sind.

13. Hochfrequenzfeld-Einrichtung nach einem der Ansprüche 1 bis 12, dadurch gekennzeichnet, daß der kleinste Abstand (a) zwischen der gedachten Zylindermantelfläche (12) und der Hülle (2) mindestens 0,5 cm, vorzugsweise 1 cm, beträgt und daß der größte Abstand (a) zwischen dieser bzw. einer weiteren gedachten Zylindermantelfläche (12) und der Hülle (2) höchstens 20 cm, vorzugsweise höchstens 10 cm beträgt.

**Claims**

1. A device for producing a substantially homogeneous magnetic high-frequency field and/or for receiving high-frequency signals in a nuclear magnetic resonance apparatus, in particular for zeugmatography, comprising at least two conductor sections (13 to 16) of predetermined length which extend parallel to the direction of the cylinder axis on an imaginary cylinder jacket surface, are traversed by current in an opposing manner, and are connected to at least one external energy supply or receiving device, characterised in

a) that at least one substantially high-frequency impermeable yet low-frequency transmissive sleeve (2) which contains electrically high conductive material is arranged around the conductor sections (13 to 16) to be concentric with respect to the imaginary cylinder jacket surface (12) at a predetermined distance and likewise connected to the energy supply or receiving device and

b) that the conductor sections (13, 14 and 15, 16) forming at least one conductor pair are respectively terminated at their end which is not connected to the energy supply or receiving device with means which reflect the waves of the high-frequency field, so that a high-frequency field (B) oscillating in phase is formed by means of the conductor system formed from the sleeve (2) and the at least one conductor pair.

2. A high-frequency field device as claimed in Claim 1, characterised by a resonant adaptation of the energy supply or receiving device and the means which reflect the waves of the high-frequency field.

3. A high-frequency field device as claimed in Claim 2, characterised by the adaptation of the energy supply or receiving device and the reflecting means in such a manner that the current antinode of the currents fed into the conductor system or received by the conductor system are at least approximately in

**0 073 375**

the axial centre of the conductor system.

4. A high-frequency field device as claimed in one of Claims 1 to 3, characterised in that the sleeve (2) is designed as a cage consisting of electrically conductive components (6 to 8) with intermediate perforations (3).

5. A high-frequency field device as claimed in one of Claims 1 to 4, characterised in that the conductor sections (13 to 16) of the at least one conductor pair are terminated with capacitances (20 to 23) of predetermined magnitude.

6. A high-frequency field device as claimed in Claim 5, characterised in that capacitors (20 to 23) or short-circuited conductor sections are inserted as capacitances between the sleeve (2) and the ends of the conductor sections (13 to 16) of the at least one conductor pair.

7. A high-frequency field device as claimed in Claim 5 or 6, characterised in that the value (C) of the capacitances (capacitors 20 to 23) is approximately determined in accordance with the formula :

$$C \approx \left[ \left| \omega \cdot z_L \cdot \tan\left(\frac{\pi \cdot L}{\lambda}\right) \right| \right]^{-1}$$

where $\omega$ is the angular frequency ; $Z_L$ is the surge impedance of a conductor section (13 to 16) against the sleeve (2) ; L is the axial extent of the sleeve (2) or the conductor sections (13 to 16) ; and $\lambda$ is the wavelength.

8. A high-frequency field device as claimed in one of Claims 1 to 7, characterised in that at least two parallel conductor sections (29 to 31) are combined to form one conductor unit (25 to 28) and that a system producing the high-frequency field is formed from the sleeve (2) and at least two of such conductor units (25 to 28), which are traversed by current in an opposing fashion.

9. A high-frequency field device as claimed in one of Claims 1 to 8, characterised by conductor sections (33 to 36) consisting of at least one strip-shaped conductor.

10. A high-frequency field device as claimed in one of Claims 1 to 9, characterised in that at least two conductor pairs are provided.

11. A high-frequency field device as claimed in Claim 10, characterised

a) by a second conductor pair which is arranged on the imaginary cylinder jacket surface (12) or a further cylinder jacket surface so as to be staggered at a predetermined angle in the peripheral direction with respect to the first conductor pair ; and

b) by a circularly polarised high-frequency field by means of a high-frequency current in the second conductor pair which is phase-shifted relative to the high-frequency current in the first conductor pair at a predetermined phase angle, where the magnitudes of the two high-frequency currents are at least approximately identical.

12. A high-frequency field device as claimed in Claim 10 or 11, characterised in that the conductor pairs are arranged on different concentric cylinder jacket surfaces.

13. A high-frequency field device as claimed in one of Claims 1 to 12, characterised in that the smallest distance (a) between the imaginary cylinder jacket surface (12) and the sleeve (2) is at least 0.5 cm, preferably 1 cm, and that the largest distance (a) between said cylinder jacket surface or a further imaginary cylinder jacket surface (12) and the sleeve (2) is at the most 20 cm, and preferably at the most 10 cm.

**Revendications**

1. Dispositif pour produire un champ magnétique à haute fréquence, au moins essentiellement homogène, et/ou pour recevoir des signaux à haute fréquence dans un appareil à résonance magnétique nucléaire, notamment pour la tomographie à résonance magnétique nucléaire (zeugmatographie), comportant au moins deux pièces conductrices (16 à 13) possédant une longueur prédéterminée, qui s'étendent sur une surface enveloppe cylindrique imaginaire parallèlement à la direction de l'axe du cylindre, sont parcourues par le courant en des sens opposés et sont reliées à au moins un dispositif extérieur d'alimentation d'énergie ou de réception, caractérisé par le fait que :

a) une enveloppe (2) au moins dans une large mesure étanche aux hautes fréquences, mais passante pour les basses fréquences et contenant un matériau électriquement bon conducteur est disposée concentriquement à une distance prédéterminée (a) par rapport à la surface enveloppe cylindrique imaginaire (12) autour des pièces conductrices (13 à 16) et est également raccordée au dispositif d'alimentation d'énergie ou de réception, et

b) que les pièces conductrices (13, 14 ou 15, 16) constituant au moins un couple de conducteurs sont terminées, respectivement au niveau de leur extrémité non reliée au dispositif d'alimentation d'énergie ou de réception, par des moyens réfléchissant les ondes du champ à haute fréquence, de manière à former, avec le système de conducteurs constitué par l'enveloppe (2) et par au moins un couple de conducteurs, un champ à haute fréquence (B) oscillant en phase.

2. Dispositif de production d'un champ à haute fréquence selon la revendication 1, caractérisé par

7

une adaptation, fournissant la résonance, du dispositif d'alimentation d'énergie ou de réception et des moyens réfléchissant les ondes du champ à haute fréquence.

3. Dispositif de production d'un champ à haute fréquence, suivant la revendication 2, caractérisé par une adaptation du dispositif d'alimentation d'énergie ou de réception et des moyens réfléchissants de telle sorte que les amplitudes d'onde maximales des courants introduits dans le système de conducteurs ou des courants reçus par le système de conducteurs sont situés au moins approximativement au milieu axial du système de conducteurs.

4. Dispositif de production d'un champ à haute fréquence, suivant l'une des revendications 1 à 3, caractérisé par le fait que l'enveloppe (2) est agencée sous la forme d'une cage constituée par des éléments électriquement conducteurs (6 à 8) comportant entre eux des passages (3).

5. Dispositif de production d'un champ à haute fréquence suivant l'une des revendications 1 à 4, caractérisé par le fait que les pièces conductrices (13 à 16) du couple de conducteurs, prévu au moins en un exemplaire, sont terminées par des capacités (20 à 23) possédant une valeur prédéterminée.

6. Dispositif de production d'un champ à haute fréquence selon la revendication 5, caractérisé en ce que, en tant que capacités, des condensateurs (20 à 23) ou des pièces conductrices courts-circuitées sont branchées entre les extrémités des pièces conductrices (13 à 16) du couple de conducteurs prévu au moins en un exemplaire, et l'enveloppe (2).

7. Dispositif de production d'un champ à haute fréquence suivant la revendication 5 ou 6, caractérisé par le fait que la valeur (C) des capacités (condensateurs 20 à 23) est déterminée de façon approchée conformément à la formule

$$C \approx \left[ \left| \omega \cdot z_L \cdot tg \left( \frac{\pi \cdot L}{\lambda} \right) \right| \right]^{-1}$$

$\omega$ étant la fréquence angulaire, $Z_L$ l'impédance caractéristique d'une pièce conductrice (13 à 16) par rapport à l'enveloppe (2), L l'étendue axiale de l'enveloppe (2) ou des pièces conductrices (13 à 16) et $\lambda$ la longueur d'onde.

8. Dispositif de production d'un champ à haute fréquence suivant l'une des revendications 1 à 7, caractérisé par le fait qu'au moins deux pièces conductrices parallèles (29 à 31) sont rassemblées pour former une unité à conducteurs (25 à 28) et qu'un système produisant le champ à haute fréquence est formé par au moins deux unités à conducteurs (25 à 28) parcourues par le courant en des sens opposés, et par l'enveloppe (2).

9. Dispositif de production d'un champ à haute fréquence suivant l'une des revendications 1 à 8, caractérisé par des pièces conductrices (33 à 36) formées par au moins un tronçon de conducteurs en forme de bande.

10. Dispositif de production d'un champ à haute fréquence suivant l'une des revendications 1 à 9, caractérisé par le fait qu'il est prévu au moins deux couples de conducteurs.

11. Dispositif de production d'un champ à haute fréquence suivant la revendication 10, caractérisé :

a) par un second couple de conducteurs, qui est disposé en étant décalé d'un angle de rotation prédéterminé suivant la direction périphérique par rapport au premier couple de conducteurs sur la surface enveloppe cylindrique imaginaire (12) ou sur une autre surface enveloppe cylindrique, et

b) par un champ à haute fréquence polarisé circulairement, réalisé au moyen d'un courant à haute fréquence circulant dans le second couple de conducteurs qui est déphasé d'un angle de phase prédéterminé, par rapport au courant à haute fréquence circulant dans le premier couple de conducteurs, les valeurs des deux courants à haute fréquence étant au moins approximativement égales.

12. Dispositif de production d'un champ à haute fréquence suivant la revendication 10 ou 11, caractérisé par le fait que les couples de conducteurs sont disposés sur différentes surfaces enveloppe cylindriques concentriques.

13. Dispositif de production d'un champ à haute fréquence suivant l'une des revendications 1 à 12, caractérisé par le fait que la distance la plus faible (a) entre la surface enveloppe cylindrique imaginaire (12) et l'enveloppe (2) est égale à au moins 0,5 cm et de préférence à 1 cm, et que la distance maximale (a) entre cette surface enveloppe cylindrique ou une autre surface enveloppe cylindrique imaginaire (12) et l'enveloppe (2) est égale au maximum à 20 cm, de préférence au maximum à 10 cm.

FIG 1

FIG 2

FIG 4

FIG 3